# FASCICULE DE BREVET EUROPEEN

(11) **EP 1 566 643 B1**
(45) Date de publication et mention de la délivrance du brevet: **05.08.2009**
(21) Numéro de dépôt: 05290337.4
(22) Date de dépôt: 15.02.2005
(51) Int. Cl.: G01R 19/00

(54) **Procédé de test en surcharge de courant d'une sortie de courant d'un equipement electrique et d'un tel equipement**
Verfahren zur Prüfung einer Ausgangüberstrom einer elektrischen Ausrüstung, sowie zur Prüfung einer solchen Ausrüstung
Method for checking-on-overload of the current output of an electrical equipment, and for checking such an equipment

(30) Priorité: 23.02.2004 FR 0401798
(43) Date de publication de la demande: 24.08.2005
(73) Titulaire: Peugeot Citroën Automobiles S.A., 78140 Vélizy Villacoublay (FR)
(72) Inventeur: Ernault, Yves, 93100 Montreuil (FR); Metalli, Didier, 78140 Velizy (FR); Magnier, Laurent, 92130 Issy-les-Moulineaux (FR)

(56) Documents cités:
- US-B1- 6 400 260

## Description

La présente invention concerne un procédé de test en surcharge de courant d'une sortie de courant d'un équipement électrique ainsi qu'un procédé de test en surcharge de courant d'un tel équipement.

Il existe aujourd'hui un nombre important d'équipements électriques de ce type adaptés pour distribuer du courant, afin par exemple, de piloter d'autres équipements disposés en aval.

On trouve notamment ce type d'équipements électriques dans les systèmes embarqués tels que les systèmes électriques d'automobiles sous la forme de calculateurs moteurs par exemple.

Un risque inhérent à ces équipements électriques est le risque accidentel de surcharge de courant de la sortie résultant, par exemple, de l'apparition d'une masse électrique sur le circuit aval diminuant l'impédance de la charge à la sortie de l'équipement et augmentant le courant.

La mise en oeuvre d'un tel courant de surcharge entraîne souvent la détérioration du fonctionnement de l'équipement, l'interruption de la distribution de courant et induit des risques de surchauffe thermique et d'incendie.

Afin de déterminer les risques auxquels sont exposés les systèmes comprenant ce type d'équipements électriques, il convient donc de s'assurer de leur comportement en surcharge de courant.

Un test classique réalisé sur les sorties distribuant du courant d'un équipement électrique est décrit par la norme ISO 16 750-2. Il consiste à mettre brièvement chaque sortie en court-circuit, c'est-à-dire à connecter la sortie à la masse au travers d'une impédance quasi nulle, pour vérifier la tenue en surcharge de courant de l'équipement.

Ce test est rapide mais présente des inconvénients importants.

En effet, il ne permet pas de prendre en compte le cas où le courant distribué par la sortie est légèrement inférieur au courant de court-circuit et ne déclenche pas les protections. De plus, la quantité d'énergie appliquée au cours de ce test ne permet pas de rendre compte des situations réelles, et notamment ne reproduit pas l'échauffement et la dégradation progressive du fonctionnement des équipements.

Il en résulte que certains équipements peuvent répondre parfaitement à ce type de tests et présenter toutefois un risque important d'incendie dans une situation réelle dégradée.

Le but de la présente invention est de résoudre ce problème en définissant un procédé de test de tenue en surcharge de courant d'une sortie distribuant du courant d'un équipement électrique de longue durée et dans des conditions proches de conditions réelles dégradées.

A cet effet, la présente invention a pour objet un procédé de test de tenue en surcharge de courant d'une sortie de courant du courant d'un équipement électrique, notamment d'un équipement électrique embarqué dans une véhicule automobile et raccordé entre une alimentation et une masse, caractérisé en ce qu'il comprend :
- le raccordement de la sortie à la masse par l'intermédiaire d'une impédance variable ;
- la détermination, par la modification de la valeur de l'impédance variable, d'une valeur de courant de test maximal distribuable sans interruption par la sortie ;
- le maintien, par l'ajustement de la valeur de l'impédance variable, d'un courant distribué par la sortie sensiblement égal au courant de test déterminé, pendant une durée de test déterminée ; et
- l'évaluation de l'état de fonctionnement de l'équipement pendant et/ou à l'issue de ladite durée de test.

Ainsi, le procédé de l'invention permet de tester une sortie d'un équipement électrique, en permettant la distribution d'une quantité d'énergie proche de la quantité maximale supportable par l'équipement afin de produire un test de longue durée, dans des conditions dégradées et prenant en compte notamment l'échauffement thermique.

Suivant d'autres caractéristiques :
- ladite durée de test pendant laquelle le courant distribué est maintenu sensiblement égal au courant de test correspond à la durée maximale d'alimentation de l'équipement en situation nominale de fonctionnement de celui-ci ;
- ladite détermination de la valeur du courant de test comprend :
   - une étape de détermination, par la modification de la valeur de l'impédance variable, d'une valeur de courant de défaillance interrompant la distribution de courant par ladite sortie ; et
   - une étape d'attribution au courant de test d'une valeur légèrement inférieure au courant de défaillance ;
- ladite sortie distribue directement du courant et ladite étape de modification de la valeur de l'impédance comprend :
   - une sous-étape de détermination de la valeur de l'impédance variable pour entraîner la distribution d'un courant nominal ; et
   - une sous-étape de modification à intervalles réguliers de la valeur de l'impédance variable pour augmenter progressivement la valeur du courant distribué jusqu'à atteindre ladite valeur du courant de défaillance ;
- ladite détermination de la valeur du courant de test comprend également une étape de remplacement de l'équipement testé ;
- ladite sortie distribue du courant au travers d'un élément de protection contre les surcharges de courant, prévu pour permettre la distribution d'un courant inférieur à une limite maximale, ladite étape de modification de la valeur de l'impédance variable comprend :
   - une sous-étape de détermination d'une valeur de l'impédance variable pour entraîner la distribution d'un courant supérieur à ladite limite maximale ; et
   - à chaque interruption de la distribution de courant par l'élément de protection, une sous-étape de modification de la valeur de l'impédance variable pour diminuer progressivement la valeur du courant distribué, et une sous-étape de remplacement de l'élément de protection jusqu'à l'obtention d'un courant distribué n'interrompant pas la distribution,
et ladite étape d'attribution comprend l'attribution de cette dernière valeur de courant au courant de test ;
- tant que la durée de ladite sous-étape de remplacement de la protection est faible par rapport à ladite durée de test, la durée de l'étape de détermination du courant de défaillance est déduite de ladite durée de test ;
- ladite sortie distribue du courant par l'intermédiaire d'un circuit électronique intégré audit équipement, et ladite détermination du courant de test comprend :
   - une étape de détermination du courant maximal délivrable par la sortie par modification de la valeur de l'impédance variable à intervalles réguliers, pour parcourir toute la plage de variation de cette impédance ; et
   - une étape d'attribution au courant de test de la valeur maximale atteinte par le courant distribué ;
- le procédé comprend en outre, avant ladite évaluation de l'état de fonctionnement de l'équipement :
   - le vieillissement accéléré de l'équipement ; et
   - la détermination d'une valeur de courant de défaillance interrompant la distribution de courant par ladite sortie, par l'ajustement de la valeur de l'impédance variable ;
- ledit vieillissement de l'équipement comprend :
   - une étape d'exposition de l'équipement à des conditions de fonctionnement dégradées ;
   - une étape de détermination de la valeur de l'impédance variable pour entraîner la distribution du courant de test ; et
   - une étape d'alternances rapides de cycles d'activation et de désactivation de l'équipement jusqu'à l'interruption de la distribution de courant ;
- la détermination du courant de défaillance comprend :
   - une étape de détermination de la valeur de l'impédance variable pour entraîner la distribution d'un courant nominal ; et
   - une étape de modification à intervalles réguliers, de la valeur de l'impédance variable pour augmenter progressivement la valeur du courant distribué jusqu'à atteindre la valeur du courant de défaillance ;
- ledit maintien d'un courant distribué sensiblement égal au courant de test comprend une étape de détermination de la valeur de l'impédance variable pour entraîner la distribution dudit courant sensiblement égal au courant de test et le maintien constant de la valeur de l'impédance variable pendant la durée de test ;
- ledit maintien d'un courant distribué sensiblement égal au courant de test comprend une étape de détermination de la valeur de l'impédance variable pour entraîner la distribution dudit courant sensiblement égal au courant de test et une étape de modification à intervalles réguliers de la valeur de l'impédance variable pour maintenir le courant de test durant ladite durée de test ;
- ladite évaluation de l'état de fonctionnement comprend :
   - une étape de contrôle visuel de l'état de l'équipement ;
   - une étape de test du fonctionnement de l'équipement en situation nominale ; et
   - une étape de classification de l'état de fonctionnement de l'équipement en fonction de ladite étape de test ;
- ladite évaluation de l'état de fonctionnement de l'équipement comprend en outre une étape de validation de l'équipement comprenant notamment une sous-étape de détermination de niveau de risque d'incendie ;
- il comprend également un test de tenue en surcharge de courant réalisé sur un autre équipement similaire à l'équipement testé et comprenant la mise en court-circuit de la sortie avec la masse pendant ladite durée de test.
- ladite détermination du courant de test et le maintien du courant distribué pendant une durée déterminée sont réalisés dans des conditions nominales de fonctionnement de l'équipement au moins au niveau de la connectique, de l'alimentation, et de l'encombrement ;
- il est réalisé sur une pluralité d'équipements électriques similaires parallèlement.

L'invention a également pour objet un procédé de test en surcharge de courant d'un équipement électrique comportant une ou plusieurs sorties de courant embarqué dans un véhicule automobile et raccordé entre une alimentation et une masse, caractérisé en ce qu'il comprend un procédé de test réalisé sur chacune des sorties successivement.

L'invention sera mieux comprise à la lecture de la description qui va suivre, donnée uniquement à titre d'exemple et faite en se référant aux dessins annexés, sur lesquels :
- la Fig.1 est un schéma bloc générique d'un équipement testé ;
- la Fig.2 est un organigramme du procédé de l'invention lorsqu'appliqué à une sortie distribuant du courant directement ;
- la Fig.3 est un organigramme du procédé de l'invention lorsqu'appliqué à une sortie distribuant du courant au travers d'une protection contre les surcharges de courant ; et
- la Fig.4 est un organigramme du procédé de l'invention lorsqu'appliqué à une sortie distribuant du courant par l'intermédiaire d'un circuit électronique.

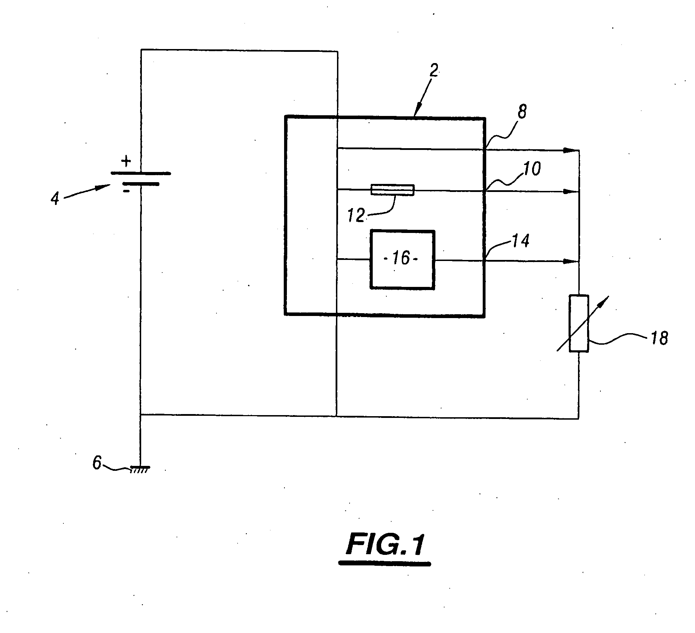

La figure 1 représente un schéma générique d'un équipement testé tel que par exemple un équipement électrique 2 de pilotage d'un moteur embarqué dans un véhicule automobile.

Cet équipement 2 est raccordé entre une alimentation 4 en énergie électrique et une masse 6.

Il comporte plusieurs sorties distribuant chacune du courant telles que par exemple, une sortie 8 distribuant directement du courant, une sortie 10 distribuant du courant par l'intermédiaire d'un élément de protection contre les surcharges de courant 12 ou fusible et une sortie 14 distribuant du courant par l'intermédiaire d'un circuit électronique 16 formé de composants discrets ou de composants intégrés.

De telles sorties 8, 10, 14 sont courantes sur les équipements électroniques et distribuent par exemple des courant supérieurs à 100 mA. En effet, dans l'environnement d'un véhicule automobile, des courants inférieurs à une telle valeur sont peu susceptibles de détériorer un équipement électrique ou de provoquer un incendie.

Bien entendu, un même équipement peut comporter plusieurs sorties d'un même type.

Dans le cadre du procédé de test de l'invention, les sorties 8, 10, 14 de l'équipement 2 sont raccordées successivement à la masse 6 par l'intermédiaire d'une impédance variable 18 au cours d'une étape préalable de raccordement.

Par ailleurs, l'équipement 2 est placé dans des conditions nominales de fonctionnement au niveau de la connectique, notamment du fait de l'utilisation des faisceaux de câbles réels associés à leur charge nominale, au niveau de l'alimentation, grâce à l'utilisation d'une batterie ou d'une alimentation stabilisée pour fournir l'alimentation 4, au niveau de l'encombrement afin de reproduire les conditions réelles d'échange thermique et au niveau de l'environnement par la régulation de la température de la zone de test.

Dans les modes de réalisation décrits, on considère que l'équipement 2 est relié à des faisceaux de câbles usuels et à une alimentation 4 stabilisée de 13,5V ou une batterie chargée. De plus, il est suspendu ou disposé sur une grille et est exposé à une température voisine de 23° C.

La mise en oeuvre d'un procédé de test en surcharge de courant dans de telles conditions de fonctionnement est classique pour des tests d'équipements électriques embarqués et ne sera pas décrite plus en détail ici.

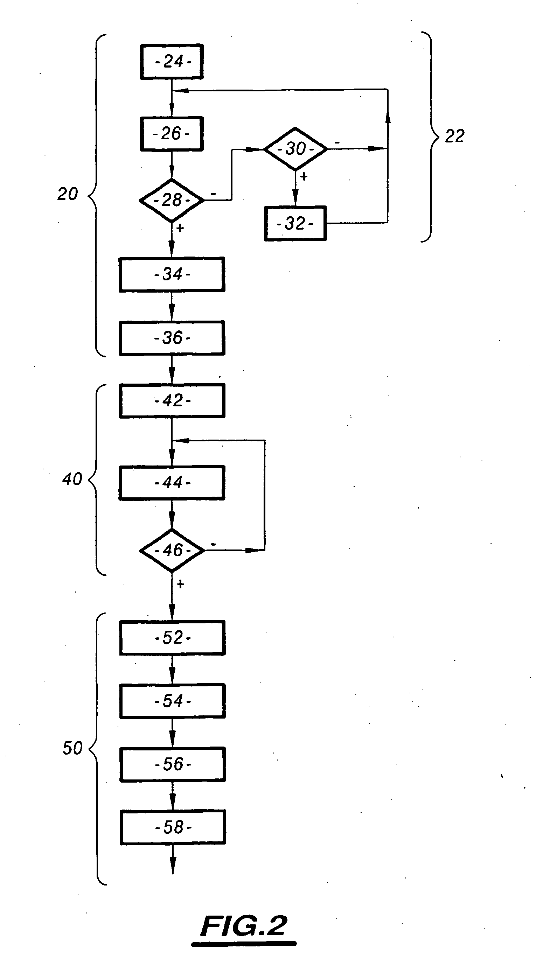

En référence à la figure 2, on va maintenir décrire le procédé de test de l'invention lorsqu'appliqué à la tenue en surcharge de courant d'une sortie distribuant directement du courant telle que la sortie 8 de l'équipement 2.

Ce procédé est mis en oeuvre dans les conditions nominales de fonctionnement décrites précédemment et débute par une détermination d'une valeur de courant maximal distribuable sans interruption de la sortie 8, dit « courant de test », désignée par la référence numérique générale 20 et obtenue par modifications successives de la valeur de l'impédance variable 18.

Dans ce mode de réalisation, cette détermination comprend une étape 22 de détermination, par la modification de la valeur de l'impédance variable 18, d'une valeur d'un courant interrompant la distribution de courant par la sortie 8, dit « courant de défaillance ».

Cette étape 22 débute par une sous-étape 24 de détermination de la valeur de l'impédance variable 18 pour entraîner la distribution d'un courant nominal par la sortie 8.

Cette sous-étape 24 est suivie d'une sous-étape 26 de mise en oeuvre de l'équipement 2 avec cette sortie 8 raccordée à la masse 6 par l'intermédiaire de l'impédance variable 18, telle que réglée lors de la sous-étape 24 afin de distribuer un courant nominal. La durée de cette sous-étape 26 est chronométrée grâce, par exemple, à l'utilisation d'un compteur.

La sous-étape 26 est suivi d'un test 28 permettant de savoir si oui ou non, la distribution de courant par la sortie 8 a été interrompue.

Dans le cas où cette sortie de courant n'a pas été interrompue, le test 28 est suivi d'un test 30, permettant de savoir si oui ou non la sous-étape 26 de mise en oeuvre a duré un temps significatif fixé expérimentalement à une durée de l'ordre de 15 mn.

Dans le cas où le résultat du test 30 est négatif, c'est-à-dire que la sous-étape 26 de mise en oeuvre n'a pas duré 15 mn, le procédé retourne à la sous-étape 26 afin de poursuivre cette mise en oeuvre.

Dans le cas inverse, c'est-à-dire lorsque la sous-étape 26 de mise en oeuvre a duré au moins 15 mn, le test 30 aboutit à une sous-étape 32 au cours de laquelle la valeur de l'impédance variable 18 est modifiée, de manière à augmenter la valeur du courant distribué par la sortie 8, par exemple de 10%.

Le compteur de temps est alors remis à zéro lors de la sous-étape 32, qui est suivie de la sous-étape 26 de mise en oeuvre de l'équipement 2 avec la nouvelle valeur d'impédance variable adaptée pour délivrer un courant de 10% supérieur au courant précédent pendant une nouvelle période de 15 mn.

La répétition des sous-étapes 26, 28, 30 et 32 forme ainsi une sous-étape de modification à intervalles réguliers de la valeur de l'impédance variable 18, pour augmenter progressivement la valeur du courant distribué jusqu'à atteindre une valeur d'impédance entraînant la distribution du courant de défaillance, ce qui interrompt la distribution de courant par la sortie 8.

Ainsi, dans ce mode de réalisation, l'étape 22 de détermination du courant de défaillance est faite de manière incrémentale à partir du courant nominal jusqu'au courant de défaillance.

L'apparition du courant de défaillance est détectée lors du test 28 qui aboutit alors à une étape 34 d'attribution au courant de test d'une valeur légèrement inférieure au courant de défaillance déterminé, telle qu'une valeur représentant 90% du courant de défaillance.

Avantageusement, l'étape 34 est suivie dans le mode de réalisation décrit d'une étape 36 de remplacement de l'équipement testé 2 par un équipement identique, le premier ayant été exposé à un courant de défaillance qui a pu l'endommager ou détériorer son fonctionnement.

A l'issue de la détermination 20 du courant de test, le procédé comprend le maintien du courant distribué par la sortie 8 à une valeur sensiblement égale à celle du courant de test pendant une durée déterminée, désigné par la référence numérique générale 40 et obtenu grâce à l'ajustement de la valeur de l'impédance variable 18.

Dans le mode de réalisation décrit, cette durée de test correspond à la durée maximale d'alimentation de l'équipement en énergie électrique en situation nominale de fonctionnement.

Ainsi, si l'équipement 2 est couramment raccordé à une batterie, la durée de test correspond à la durée de décharge de la batterie dans l'équipement 2, soit par exemple une durée de deux heures.

Avantageusement, le maintien 40 débute par une étape 42 de détermination de la valeur de l'impédance variable pour entraîner la distribution par la sortie 8 d'un courant sensiblement égal au courant de test déterminé précédemment.

Une telle étape 42 permet de prendre en compte les différences existant entre deux équipements de même nature, l'impédance nécessaire à la distribution du courant de test pouvant être légèrement différente entre l'équipement utilisé pour la détermination 20 du courant de test et l'équipement utilisé lors du maintien 40 du courant de test.

L'étape 42 est suivie d'une étape 44 de mise en oeuvre chronométrée de l'équipement 2, avec la valeur d'impédance variable déterminée précédemment.

L'étape 44 est suivie d'un test 46 pour déterminer si oui ou non, l'étape 44 de mise en oeuvre de l'équipement 2 a été réalisée pendant la durée de test.

Si le test 46 révèle que la durée de test n'est pas écoulée, il renvoie à l'étape 44 de mise en oeuvre.

Le maintien 40 d'un courant distribué par la sortie 8 sensiblement égal au courant de test, c'est-à-dire correspondant au courant maximal distribuable sans interruption pendant la durée de test correspondant à la durée maximale d'alimentation, permet de reproduire la situation la plus dégradée en termes de transfert d'énergie électrique et permet donc la prise en compte de phénomènes d'échauffement thermique.

Par ailleurs, dans le mode de réalisation décrit, le fonctionnement de l'équipement 2 est évalué en continu au cours de l'étape 44 de mise en oeuvre.

A l'issue de la durée de test, le procédé comprend une évaluation de l'état de fonctionnement de l'équipement 2, désignée par la référence numérique générale 50.

Cette évaluation 50 comporte une étape 52 de contrôle visuel de l'état de l'équipement suivie d'une étape 54 de test du fonctionnement de l'équipement 2 dans une situation nominale qui inclut l'évaluation faite en continue au cours de l'étape 44 et une étape 56 de classification de l'état de fonctionnement de l'équipement 2.

Dans le mode de réalisation décrit, cette étape 56 de classification est fondée sur les classes de degré de gravité de mauvais fonctionnement définies dans la norme ISO 7637-2, c'est-à-dire sur les cinq classes suivantes :
- classe A : toutes les fonctions de l'équipement 2 sont assurées normalement après l'essai ;
- classe B : toutes les fonctions de l'équipement 2 sont assurées pendant l'essai, cependant l'une ou plusieurs d'entre elles peuvent sortir des tolérances spécifiées, toutes les fonctions reviennent automatiquement dans les limites normales après l'essai, les mémoires doivent rester conformes à la classe A;
- classe C : une fonction de l'équipement 2 n'est pas assurée normalement pendant l'essai, mais revient automatiquement à la normale après :
- classe D : une fonction de l'équipement 2 n'est pas assurée normalement pendant l'essai, et ne revient pas à la normale après, l'équipement 2 est réinitialisé par une manoeuvre de l'utilisateur ; et
- classe E : une ou plusieurs fonctions de l'équipement 2 ne sont pas assurées normalement pendant et après l'essai et il n'est pas possible de retrouver un fonctionnement nominal sans réparer ou remplacer l'équipement.

Avantageusement, l'évaluation 50 comporte en outre une étape 58 de validation de l'équipement 2 en fonction de critères qui lui sont spécifiques.

Ainsi, il peut être exigé qu'un équipement assurant des fonctions de sécurité à bord d'un véhicule automobile présente une classification de type A à l'issue de ce procédé de test.

De plus, l'étape 58 de validation comprend, dans le mode de réalisation décrit, une sous-étape d'évaluation du risque d'incendie, fondée par exemple sur la constatation de l'apparition de flammes ou d'une élévation de température susceptible de provoquer l'inflammation d'équipements voisins.

Dans le mode de réalisation décrit, le maintien 40 du courant distribué par la sortie 8 à une valeur sensiblement égale à celle du courant de test, est assuré grâce à la détermination des conditions de fonctionnement au début du test et à leur constance pendant la durée de test.

En variante, il est possible de prévoir une boucle de contre-réaction permettant de prendre en compte des variations dans le temps de la charge présente à la sortie de l'équipement 2, dues notamment à l'échauffement de la partie connectique.

Dans un tel mode de réalisation, il est prévu durant le maintien 40 du courant distribué, une étape de mesure du courant de sortie et une étape automatique de modification de la valeur de l'impédance variable, pour corriger le courant distribué et le maintenir égal au courant de test.

Il apparaît donc que le procédé de l'invention permet d'effectuer un test de longue durée de surcharge de courant d'une sortie en reproduisant les conditions les plus critiques de transfert d'énergie et d'échauffement thermique.

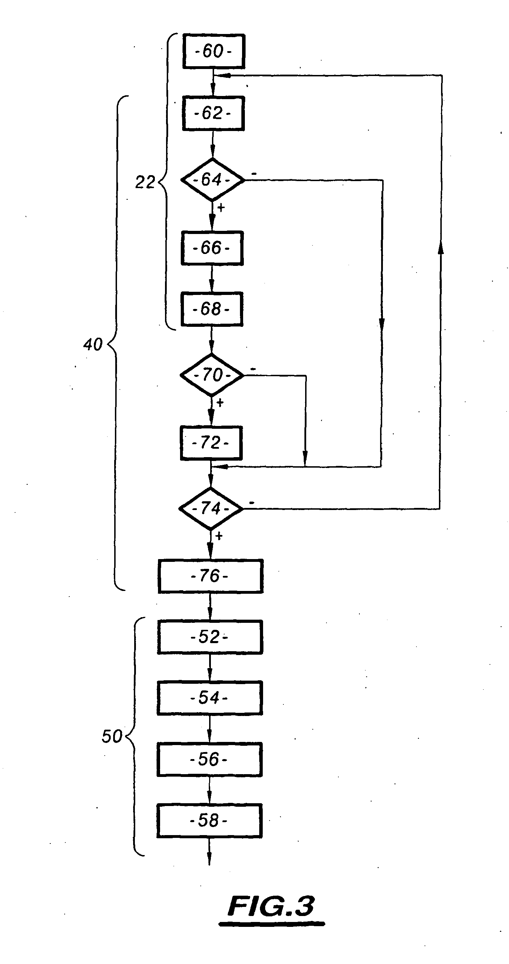

En référence à la figure 3, on va maintenant décrire un autre mode de réalisation du procédé de l'invention, lorsqu'appliqué à une sortie délivrant du courant au travers d'un élément de protection contre les surcharges de courant, telle que la sortie 10 équipée du fusible 12.

De manière classique, le fusible 12 est prévu pour permettre la distribution d'un courant inférieur à une limite maximale.

Dans ce mode de réalisation, l'étape 22 de détermination du courant de défaillance comporte une sous-étape 60 de détermination de la valeur de l'impédance variable 18 pour entraîner la distribution d'un courant supérieur à la limite maximale de fonctionnement du fusible 12.

Par exemple, la valeur de l'impédance variable 18 est choisie pour entraîner la distribution d'un courant correspondant à 140% du calibre du fusible 12 de la sortie 10.

Le procédé comporte ensuite une sous-étape 62 de mise en oeuvre de l'équipement 2, dans des conditions nominales de fonctionnement telles que décrites précédemment, et avec la valeur d'impédance variable déterminée lors de la sous-étape 60. Cette sous-étape 62 est chronométrée.

La sous-étape 62 est suivie d'un test 64 pour savoir si oui ou non il y a eu interruption de la distribution de courant par la sortie 10.

Si ce test est positif, c'est-à-dire si la valeur de l'impédance variable entraîne la distribution d'un courant supérieur au courant de défaillance, le test 64 est suivi d'une sous-étape 66 de modification de la valeur de l'impédance pour diminuer la valeur du courant distribué.

Dans le mode de réalisation décrit, cette sous-étape de modification 66 aboutit à la diminution du courant distribué d'une valeur expérimentale de 2% de la valeur du calibre du fusible 12.

La sous-étape 66 est suivie d'une sous-étape 68 de remplacement du fusible 12 afin de permettre de remettre en oeuvre l'équipement 2.

Ainsi, dans ce mode de réalisation, l'étape 22 de détermination du courant de défaillance comporte, à chaque interruption de la distribution de courant par le fusible 12, une sous-étape 66 de modification de la valeur de l'impédance variable 18 et une sous-étape 68 de remplacement du fusible 12, pour diminuer progressivement la valeur du courant distribué jusqu'à l'obtention d'un courant n'interrompant pas la distribution.

Dans le mode de réalisation décrit, afin de prendre en compte les effets de l'échauffement thermique, il convient de s'assurer que le remplacement du fusible lors de la sous-étape 68 ne perturbe pas la nature du test.

A cet effet, la sous-étape 68 est suivie d'un test 70 pour savoir si oui ou non la durée de cette sous-étape 68 de remplacement est faible par rapport à la durée de test totale, c'est-à-dire par exemple inférieure à 1% de la durée de test, soit une durée de la sous-étape 68 de remplacement de l'ordre d'une minute.

Si ce test est positif, c'est-à-dire si la durée de la sous-étape 68 de remplacement du fusible 12 est supérieure à 1 mn, le test 70 est suivi d'une étape 72 de remise à zéro du compteur de temps de la sous-étape 62 permettant le décompte de la durée de test, de manière à reprendre l'intégralité de la durée de test.

Inversement, si le test 70 révèle que la durée de la sous-étape 68 de remplacement du fusible 12 est inférieure à 1 mn, la sous-étape 72 n'est pas réalisée, de sorte que la durée de l'étape 22 de détermination du courant de défaillance est déduite de la durée de test.

Le procédé comporte ensuite un test 74 permettant de savoir si la durée de test a été atteinte ou non.

Ce test 74 est réalisé à l'issue du remplacement du fusible 12 après une interruption ou directement à l'issue du test 64 en l'absence d'interruption.

Tant que la durée de test n'est pas atteinte, le test 74 renvoie à la sous-étape 62 de mise en oeuvre afin de poursuivre le maintien 40 du courant distribué.

Lorsque la durée de test est atteinte, c'est-à-dire lorsque le résultat du test 74 est positif, le procédé comprend une étape 76 d'attribution de la valeur du courant distribué au courant de test.

Le courant ainsi obtenu est d'une valeur légèrement inférieure au courant de défaillance et forme directement le courant de test, de sorte que l'étape 22 de détermination du courant de défaillance et l'étape 76 forment la détermination 20 du courant de test.

Ainsi, dans ce mode de réalisation, la valeur du courant de test est déterminée par décrémentation à partir d'une valeur supérieure au maximum de la plage du fusible 12 et par diminutions successives jusqu'à l'obtention d'un courant inférieur à un courant de défaillance.

De plus, le maintien 40 de la valeur de l'impédance variable pendant la durée de test est réalisé simultanément à la détermination 20 du courant de test.

L'étape 76 d'attribution de la valeur du courant de test est suivie des étapes 52, 54, 56 et avantageusement 58, formant l'évaluation 50 de l'état de fonctionnement de l'équipement 2 qui a été décrite en référence à la figure 2.

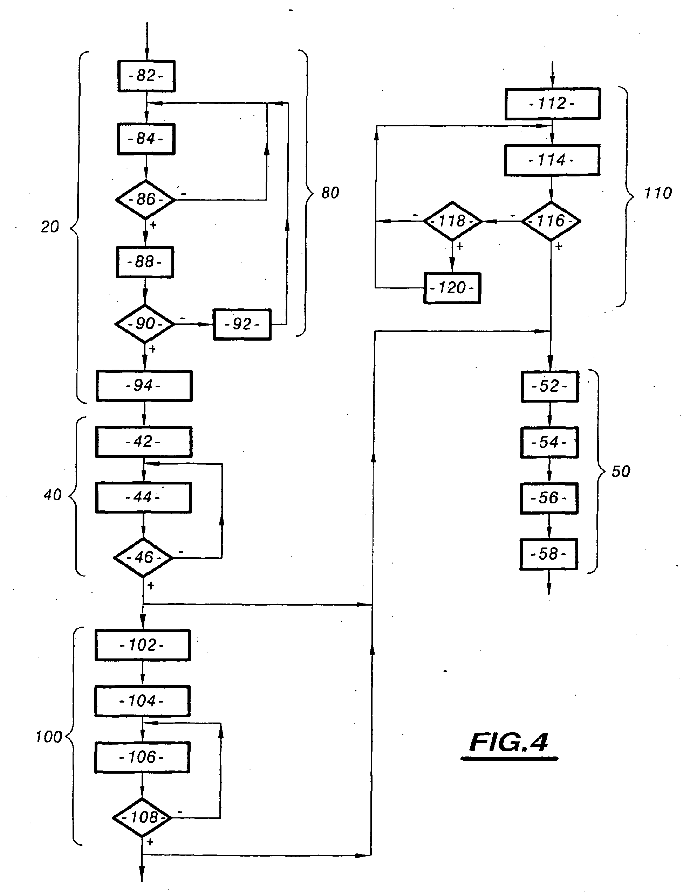

En référence à la figure 4, on va maintenant décrire l'application du procédé de l'invention au test d'une sortie distribuant du courant par l'intermédiaire d'un circuit électronique intégré à l'équipement 2, telle que par exemple la sortie 14 distribuant du courant par l'intermédiaire du circuit électronique 16.

Dans un tel mode de réalisation, il est normalement impossible d'amener la sortie 14 à distribuer un courant de défaillance.

En effet, les différents composants électroniques formant le circuit électronique 16 limitent le courant distribuable, soit physiquement de par leurs capacités intrinsèques, soit par l'intermédiaire d'une stratégie logiciel.

Dans ce mode de réalisation, la détermination 20 du courant de test comporte une étape 80 de détermination du courant maximal distribuable par des modifications de la valeur de l'impédance variable 18 répétées de manière à parcourir progressivement toute la plage de variation de cette impédance 18.

Cette étape 80 comprend une sous-étape 82 de détermination d'une valeur extrême de l'impédance variable suivie d'une sous-étape 84 de mise en oeuvre de l'équipement 2 avec l'impédance variable déterminée précédemment.

La sous-étape 84 est suivie d'un test 86 pour déterminer si oui ou non chaque valeur testée de l'impédance 18 a été maintenue pendant un temps significatif, tel que par exemple un temps expérimentalement fixé à 15 minutes.

Dans le cas où cette durée est inférieure à la durée de 15 minutes, le test 86 renvoie à la sous-étape 84 de mise en oeuvre.

Lorsque la valeur en cours a été testée pendant 15 minutes, le test 86 est suivi d'une sous-étape 88 de mesure et d'enregistrement du courant distribué par la sortie 14.

La sous-étape 88 est suivie d'un test 90 pour déterminer si oui ou non toute la plage de valeurs possibles pour l'impédance variable 18 a été éprouvée. Dans le cas où le résultat de ce test est négatif, c'est-à-dire où toute la plage de valeurs possibles n'a pas été éprouvée, le test 90 renvoie à une sous-étape 92 de modification de la valeur de l'impédance variable de manière à mettre en oeuvre une autre valeur d'impédance. La sous-étape 92 est elle-même suivie de la sous-étape 84 de mise en oeuvre.

Avantageusement, les modifications de la valeur de l'impédance variable 18 sont faites par incréments successifs, la valeur du pas étant déterminée par un compromis entre la précision des mesures et la durée du test.

Lorsque toute la plage de valeurs de l'impédance variable 18 a été éprouvée, le test 90 est positif et aboutit à une étape 94 d'attribution au courant de test de la valeur maximale atteinte par le courant distribué.

Le procédé comprend ensuite le maintien du courant distribué par la sortie 14 à une valeur sensiblement égale à la valeur du courant de test pendant la durée de test. Ce maintien 40 comprend les étapes 42, 44 et 46 décrites précédemment en référence à la figure 2.

Dans une variante de réalisation, le procédé comporte directement après le maintien 40, l'évaluation 50 telle que décrite précédemment.

Alternativement, le procédé comporte à l'issue du maintien 40 le vieillissement accéléré de l'équipement 2, désigné par la référence numérique générale 100. Ce vieillissement accéléré comporte une étape 102 d'exposition de l'équipement 2 à des conditions de fonctionnement dégradées, soit par exemple à des conditions de température inférieures aux conditions de fonctionnement normales ainsi qu'à des conditions d'alimentation supérieures aux conditions d'alimentation normales.

Dans l'exemple décrit, l'équipement 2 est placé à une température de -30°C et reçoit une alimentation de 16,5V, soit supérieure de 25% à son alimentation nominale.

L'étape 102 est suivie d'une étape 104 de détermination de la valeur de l'impédance variable pour entraîner la distribution du courant de test et d'une étape 106 d'alternances rapides de cycles d'activation et de désactivation de l'équipement 2.

L'étape 106 est suivie d'un test 108 pour savoir s'il y a eu oui ou non interruption de la distribution de courant.

Dans le cas où il n'y a pas eu d'interruption de courant, le test 108 renvoie à l'étape 106 d'alternances rapides d'activation et de désactivation de l'équipement 2 jusqu'à ce qu'il soit positif, c'est-à-dire jusqu'à ce qu'il y ait eu une interruption de la distribution de courant par la sortie 14.

Dans une variante, le vieillissement 100 est directement suivi par l'évaluation 50.

Alternativement, le procédé comporte ensuite une distribution 110 d'un courant de défaillance par l'ajustement de la valeur de l'impédance variable.

En effet, après avoir subi le vieillissement 100 et avoir atteint une première fois un courant de défaillance, l'équipement est susceptible de l'atteindre à nouveau dans des conditions nominales de fonctionnement.

Bien entendu, la réalisation de la distribution 110 est conditionnée par la capacité de l'équipement 2 ayant subi le vieillissement 100 à encore distribuer du courant dans des conditions nominales de fonctionnement.

La distribution 110 comprend une étape 112 de détermination de la valeur de l'impédance variable pour entraîner la distribution d'un courant nominal dans des conditions nominales de fonctionnement telles que décrites précédemment.

Cette étape 112 est suivie d'une étape 114 de mise en oeuvre de l'équipement 2 avec cette sortie 14 raccordée à la masse 6 par l'intermédiaire de l'impédance variable 18, telle que réglée lors de l'étape 112 afin de délivrer un courant nominal. La durée de cette étape 114 est chronométrée.

L'étape 114 est suivie d'un test 116 permettant de savoir si oui ou non, la distribution de courant par la sortie 14 a été interrompue.

Dans le cas où cette sortie de courant n'a pas été interrompue, le test 116 est suivi d'un test 118, permettant de savoir si oui ou non l'étape 114 de mise en oeuvre a duré un temps significatif fixé expérimentalement à une durée de l'ordre de 15 mn.

Dans le cas où le résultat du test 118 est négatif, le procédé retourne à l'étape 114 afin de poursuivre cette mise en oeuvre.

Dans le cas inverse, le test 118 aboutit à une étape 120 au cours de laquelle la valeur de l'impédance variable 18 est modifiée, de manière à augmenter la valeur du courant distribué par la sortie 14, par exemple de 10%.

Le compteur de temps est alors remis à zéro lors de l'étape 120, qui est suivie de l'étape 114 de mise en oeuvre de l'équipement 2 avec la nouvelle valeur d'impédance variable adaptée pour délivrer un courant de 10% supérieur au courant précédent.

La répétition des étapes 114, 116, 118 et 120 forme ainsi la modification à intervalles réguliers de la valeur de l'impédance variable 18 pour augmenter progressivement la valeur du courant distribué jusqu'à atteindre une valeur d'impédance entraînant la distribution du courant de défaillance interrompant la distribution de courant par la sortie 14.

Dans le cas où le test 116 indique que le courant de défaillance a été atteint, le procédé se rend à l'évaluation 50.

Avantageusement, chacun des procédés de l'invention décrits précédemment peut être réalisé sur une pluralité d'équipements électriques successivement ou en parallèle afin de permettre un constat statistique de la tenue en surcharge d'un équipement.

Notamment, dans le mode de réalisation décrit en référence à la figure 4, il convient de mettre en oeuvre le vieillissement 100 et la distribution 110 du courant de défaillance sur une partie seulement des équipements testés afin de pouvoir évaluer des équipements à l'issue des seules étapes 20 et 40.

Par ailleurs, dans tous les modes de réalisation décrits, il convient de choisir le pas des modifications de l'impédance variable 18 ainsi que la durée de chaque mise en oeuvre de manière judicieuse afin de préserver la précision du test sans aboutir à un test d'une durée excessive.

Avantageusement, à des fins de comparaison, le procédé de l'invention comporte également un test de tenue en surcharge de courant réalisé sur un équipement 2 fondé sur la mise en court-circuit de la sortie, c'est-à-dire le raccordement de la sortie directement à la masse avec une impédance sensiblement nulle pendant la durée de test.

Enfin, il est évident que lorsqu'un équipement présente une pluralité de sorties distribuant chacune du courant, il convient de le mettre en oeuvre sur chacune des sorties successivement afin de réaliser un test complet d'un tel équipement.

## Revendications

1. Procédé de test de tenue en surcharge de courant d'une sortie de courant (8, 10, 14) du courant d'un équipement électrique (2), notamment d'un équipement électrique (2) embarqué dans un véhicule automobile et raccordé entre une alimentation (4) et une masse (6), **caractérisé en ce qu'**il comprend :
- le raccordement de la sortie (8, 10, 14) à la masse (6) par l'intermédiaire d'une impédance variable (18);
- la détermination (20), par la modification de la valeur de l'impédance variable (18), d'une valeur de courant de test maximal distribuable sans interruption par la sortie (8, 10, 14) ;
- le maintien (40), par l'ajustement de la valeur de l'impédance variable, d'un courant distribué par la sortie (8, 10, 14) sensiblement égal au courant de test déterminé, pendant une durée de test déterminée ; et
- l'évaluation (50) de l'état de fonctionnement de l'équipement (2) pendant et/ou à l'issue de ladite durée de test.

2. Procédé selon la revendication 1, **caractérisé en ce que** ladite durée de test pendant laquelle le courant distribué est maintenu sensiblement égal au courant de test correspond à la durée maximale d'alimentation de l'équipement (2) en situation nominale de fonctionnement de celui-ci.

3. Procédé selon l'une quelconque des revendications 1 et 2, **caractérisé en ce que** ladite détermination (20) de la valeur du courant de test comprend :
- une étape de détermination (22), par la modification de ta valeur de l'impédance variable (18), d'une valeur de courant de défaillance interrompant la distribution de courant par ladite sortie (8, 10) ; et
- une étape (34, 76) d'attribution au courant de test d'une valeur légèrement inférieure au courant de défaillance.

4. Procédé selon la revendication 3, **caractérisé en ce que** ladite sortie (8) distribue directement du courant et **en ce que** ladite étape de modification de la valeur de l'impédance comprend :
- une sous-étape (24) de détermination de la valeur de l'impédance variable (18) pour entraîner la distribution d'un courant nominal ; et
- une sous-étape (26, 28, 30, 32) de modification à intervalles réguliers de la valeur de l'impédance variable (18) pour augmenter progressivement la valeur du courant distribué jusqu'à atteindre ladite valeur du courant de défaillance.

5. Procédé selon la revendication 4, **caractérisé en ce que** ladite détermination (20) de la valeur du courant de test comprend également une étape (32) de remplacement de l'équipement testé (2).

6. Procédé selon la revendication 3, **caractérisé en ce que** ladite sortie (10) distribue du courant au travers d'un élément de protection (12) contre les surcharges de courant, prévu pour permettre la distribution d'un courant inférieur à une limite maximale, **en ce que** ladite étape de modification de la valeur de l'impédance variable comprend :
- une sous-étape (60) de détermination d'une valeur de l'impédance variable (18) pour entraîner la distribution d'un courant supérieur à ladite limite maximale ; et
- à chaque interruption de la distribution de courant par l'élément de protection (12), une sous-étape (66) de modification de la valeur de l'impédance variable (18) pour diminuer progressivement la valeur du courant distribué, et une sous-étape (68) de remplacement de l'élément de protection (12) jusqu'à l'obtention d'un courant distribué n'interrompant pas la distribution,
et **en ce que** ladite étape d'attribution (76) comprend l'attribution de cette dernière valeur de courant au courant de test.

7. Procédé selon la revendication 6, **caractérisé en ce que**, tant que la durée de ladite sous-étape (68) de remplacement de la protection (12) est faible par rapport à ladite durée de test, la durée de l'étape (22) de détermination du courant de défaillance est déduite de ladite durée de test.

8. Procédé selon l'une quelconque des revendications 1 et 2, **caractérisé en ce que** ladite sortie (14) distribue du courant par l'intermédiaire d'un circuit électronique (16) intégré audit équipement (2), et **en ce que** ladite détermination (20) du courant de test comprend :
- une étape (80) de détermination du courant maximal délivrable par la sortie (14) par modification de la valeur de l'impédance variable (18) à intervalles réguliers, pour parcourir toute la plage de variation de cette impédance (18) ; et
- une étape (94) d'attribution au courant de test de la valeur maximale atteinte par le courant distribué.

9. Procédé selon la revendication 8, **caractérisé en ce qu'**il comprend en outre, avant ladite évaluation (50) de l'état de fonctionnement de l'équipement (2) :
- le vieillissement (100) accéléré de l'équipement (2) ; et
- la détermination d'une valeur de courant de défaillance interrompant la distribution de courant par ladite sortie (14), par l'ajustement de la valeur de l'impédance variable (18).

10. Procédé selon la revendication 9, **caractérisé en ce que** ledit vieillissement (100) de l'équipement comprend :
- une étape (102) d'exposition de l'équipement (2) à des conditions de fonctionnement dégradées ;
- une étape (104) de détermination de la valeur de l'impédance variable pour entraîner la distribution du courant de test ; et
- une étape (106) d'alternances rapides de cycles d'activation et de désactivation de l'équipement (2) jusqu'à l'interruption de la distribution de courant.

11. Procédé selon l'une quelconque des revendications 9 et 10, **caractérisé en ce que** la détermination (110) du courant de défaillance comprend :
- une étape (112) de détermination de la valeur de l'impédance variable pour entraîner la distribution d'un courant nominal ; et
- une étape (114, 116, 118, 120) de modification à intervalles réguliers de la valeur de l'impédance variable (18) pour augmenter progressivement la valeur du courant distribué jusqu'à atteindre la valeur du courant de défaillance.

12. Procédé selon l'une quelconque des revendications 1 à 11, **caractérisé en ce que** ledit maintien (40) d'un courant distribué sensiblement égal au courant de test comprend une étape (42) de détermination de la valeur de l'impédance variable (12) pour entraîner la distribution dudit courant sensiblement égal au courant de test et le maintien constant de la valeur de l'impédance variable (18) pendant la durée de test.

13. Procédé selon l'une quelconque des revendications 1 à 11, **caractérisé en ce que** ledit maintien (40) d'un courant distribué sensiblement égal au courant de test comprend une étape (42) de détermination de la valeur de l'impédance variable (12) pour entraîner la distribution dudit courant sensiblement égal au courant de test et une étape de modification à intervalles réguliers de la valeur de l'impédance variable pour maintenir le courant de test durant ladite durée de test.

14. Procédé selon l'une quelconque des revendications 1 à 13, **caractérisé en ce que** ladite évaluation (50) de l'état de fonctionnement comprend :
- une étape (52) de contrôle visuel de l'état de l'équipement (2) ;
- une étape (54) de test du fonctionnement de l'équipement (2) en situation nominale ; et
- une étape (56) de classification de l'état de fonctionnement de l'équipement (2) en fonction de ladite étape de test.

15. Procédé selon la revendication 14, **caractérisé en ce que** ladite évaluation (50) de l'état de fonctionnement de l'équipement comprend en outre une étape (58) de validation de l'équipement (2) comprenant notamment une sous-étape de détermination de niveau de risque d'incendie.

16. Procédé selon l'une quelconque des revendications 1 à 15, **caractérisé en ce qu'**il comprend également un test de tenue en surcharge de courant réalisé sur un autre équipement similaire à l'équipement testé (2) et comprenant la mise en court-circuit de la sortie (8, 10, 14) avec la masse (6) pendant ladite durée de test.

17. Procédé selon l'une quelconque des revendications 1 à 16, **caractérisé en ce que** ladite détermination du courant de test et le maintien du courant distribué pendant une durée déterminée sont réalisés dans des conditions nominales de fonctionnement de l'équipement au moins au niveau de la connectique, de l'alimentation, et de l'encombrement.

18. Procédé selon l'une quelconque des revendications 1 à 17, **caractérisé en ce qu'**il est réalisé sur une pluralité d'équipements électriques similaires parallèlement.

19. Procédé de test en surcharge de courant d'un équipement électrique (2) comportant une ou plusieurs sorties de courant embarqué dans un véhicule automobile et raccordé entre une alimentation (4) et une masse (6), **caractérisé en ce qu'**il comprend un procédé de test selon l'une quelconque des revendications 1 à 18, réalisé sur chacune des sorties successivement.

## Claims

1. Method for testing the current overload behaviour of a current output (8, 10, 14) of the current of an item of electrical equipment (2), particularly of an item of electrical equipment (2) on board a motor vehicle and connected between a power supply (4) and an earth (6), **characterized in that** it comprises:
- the connection of the output (8, 10, 14) to the earth (6) by means of a variable impedance (18);
- the determination (20), by changing the value of the variable impedance (18), of a maximum test current value that can be delivered without interruption by the output (8, 10, 14);
- the maintenance (40), by adjusting the value of the variable impedance, of a current delivered by the output (8, 10, 14) substantially equal to the determined test current, for a determined test duration; and
- the evaluation (50) of the state of operation of the equipment (2) during and/or after the said test duration.

2. Method according to Claim 1, **characterized in that** the said test duration during which the delivered current is maintained substantially equal to the test current corresponds to the maximum duration of power supply of the equipment (2) in a nominal situation of operation of the latter.

3. Method according to either one of Claims 1 or 2,
**characterized in that** the said determination (20) of the value of the test current comprises:
- a step of determination (22), by changing the value of the variable impedance (18), of a failure current value interrupting the delivery of current by the said output (8, 10); and
- a step (34, 76) of allocating to the test current a slightly lower value than the failure current.

4. Method according to Claim 3, **characterized in that** the said output (8) directly delivers current and **in that** the said step of changing the impedance value comprises:
- a substep (24) of determining the variable impedance value (18) in order to cause the delivery of a nominal current; and
- a substep (26, 28, 30, 32) of changing, at regular intervals, the value of the variable impedance (18) in order to progressively increase the value of the delivered current until the said failure current value is reached.

5. Method according to Claim 4, **characterized in that** the said determination (20) of the value of the test current also comprises a step (32) of replacing the tested equipment (2).

6. Method according to Claim 3, **characterized in that** the said output (10) delivers current through an element of protection (12) against current overloads, provided in order to allow the delivery of a current below a maximum limit, **in that** the said step of changing the variable impedance value comprises:
- a substep (60) of determining a variable impedance value (18) in order to cause the delivery of a current higher than the said maximum limit; and
- on each interruption of the delivery of current by the protection element (12), a substep (66) of modifying the variable impedance value (18) in order to progressively reduce the value of the current delivered, and a substep (68) of replacing the protection element (12) until a delivered current that does not interrupt the delivery is obtained, and **in that** the said allocation step (76) comprises the allocation of the latter current value to the test current.

7. Method according to Claim 6, **characterized in that,** while the duration of the said substep (68) of replacing the protection (12) is short relative to the said test duration, the duration of the step (22) of determining the failure current is deduced from the said test duration.

8. Method according to either one of Claims 1 or 2, **characterized in that** the said output (14) delivers current by means of an electronic circuit (16) integrated into the said equipment (2), and **in that** the said determination (20) of the test current comprises:
- a step (80) of determining the maximum current that can be delivered by the output (14) by modifying the variable impedance value (18) at regular intervals, in order to run through the full range of variation of this impedance (18); and
- a step (94) of allocating to the test current the maximum value achieved by the delivered current.

9. Method according to Claim 8, **characterized in that** it also comprises, before the said evaluation (50) of the state of operation of the equipment (2):
- the accelerated ageing (100) of the equipment (2); and
- the determination of a value of failure current interrupting the delivery of current by the said output (14), by adjusting the value of the variable impedance (18).

10. Method according to Claim 9, **characterized in that** the said ageing (100) of the equipment comprises:
- a step (102) of exposing the equipment (2) to degraded operating conditions;
- a step (104) of determining the value of the variable impedance in order to cause the delivery of the test current; and
- a step (106) of rapid alternation of cycles of activation and deactivation of the equipment (2) until the interruption of the delivery of current.

11. Method according to either one of Claims 9 or 10, **characterized in that** the determination (110) of the failure current comprises:
- a step (112) of determining the value of the variable impedance in order to cause the delivery of a nominal current; and
- a step (114, 116, 118, 120) of changing at regular intervals the value of the variable impedance (18) in order to progressively increase the value of the delivered current until the value of the failure current is reached.

12. Method according to any one of Claims 1 to 11, **characterized in that** the said maintenance (40) of a delivered current substantially equal to the test current comprises a step (42) of determining the value of the variable impedance (12) in order to cause the delivery of the said current substantially equal to the test current and the constant maintenance of the value of the variable impedance (18) during the test duration.

13. Method according to any one of Claims 1 to 11, **characterized in that** the said maintenance (40) of a delivered current substantially equal to the test current comprises a step (42) of determining the value of the variable impedance (12) in order to cause the delivery of the said current substantially equal to the test current and a step of changing at regular intervals the value of the variable impedance in order to maintain the test current during the said test duration.

14. Method according to any one of Claims 1 to 13, **characterized in that** the said evaluation (50) of the state of operation comprises:
- a step (52) of visually inspecting the state of the equipment (2);
- a step (54) of testing the operation of the equipment (2) in the nominal situation; and
- a step (56) of classifying the state of operation of the equipment (2) according to the said test step.

15. Method according to Claim 14, **characterized in that** the said evaluation (50) of the state of operation of the equipment also comprises a step (58) of validating the equipment (2) comprising in particular a substep of determining the level of fire risk.

16. Method according to any one of Claims 1 to 15, **characterized in that** it also comprises a test of current overload behaviour carried out on another item of equipment similar to the equipment tested (2) and comprising the short-circuiting of the output (8, 10, 14) with the earth (6) during the said test duration.

17. Method according to any one of Claims 1 to 16, **characterized in that** the said determination of the test current and the maintenance of the current delivered during a determined duration are carried out in nominal conditions of operation of the equipment at least on the connector technology, the power supply, and the space requirement.

18. Method according to any one of Claims 1 to 17, **characterized in that** it is carried out on a plurality of similar items of electrical equipment in parallel.

19. Method for testing the current overload of an item of electrical equipment (2) comprising one or more current outputs on board a motor vehicle and connected between a power supply (4) and an earth (6), **characterized in that** it comprises a test method according to any one of Claims 1 to 18, carried out on each of the outputs in succession.

## Patentansprüche

1. Verfahren zur Prüfung der Überstromfestigkeit eines Stromausgangs (8, 10, 14) des Stroms einer elektrischen Einrichtung (2), insbesondere einer elektrischen Einrichtung (2), die sich an Bord eines Kraftfahrzeugs befindet und zwischen einer Stromversorgung (4) und einer Masse (6) geschaltet ist, **dadurch gekennzeichnet, dass** es beinhaltet:
- das Verbinden des Ausgangs (8, 10, 14) mit der Masse (6) über eine variable Impedanz (18) ;
- die Bestimmung (20), durch die Änderung des Wertes der variablen Impedanz (18), eines maximalen Prüfstromwertes, der ohne Unterbrechung durch den Ausgang (8, 10, 14) verteilbar ist;
- die Aufrechterhaltung (40), durch die Anpassung des Wertes der variablen Impedanz, eines durch den Ausgang (8, 10, 14) verteilten Stroms, so dass er im Wesentlichen gleich dem bestimmten Prüfstrom ist, während einer bestimmten Prüfdauer; und
- die Bewertung (50) des Funktionszustands der Einrichtung (2) während und/oder am Ende der Prüfdauer.

2. Verfahren nach Anspruch 1, **dadurch gekennzeichnet, dass** die Prüfstromdauer, während welcher der verteilte Strom so aufrechterhalten wird, dass er im Wesentlichen gleich dem Prüfstrom ist, der maximalen Stromversorgungsdauer der Einrichtung (2) unter Nennbetriebsbedingungen derselben entspricht.

3. Verfahren nach einem der Ansprüche 1 und 2, **dadurch gekennzeichnet, dass** die Bestimmung (20) des Prüfstromwertes beinhaltet:
- einen Schritt der Bestimmung (22), durch die Änderung des Wertes der variablen Impedanz (18), eines Ausfallstromwertes, der die Verteilung von Strom durch den Ausgang (8, 10) unterbricht; und
- einen Schritt (34, 76) der Zuweisung eines Wertes zu dem Prüfstrom, der etwas niedriger als der Ausfallstrom ist.

4. Verfahren nach Anspruch 3, **dadurch gekennzeichnet, dass** der Ausgang (8) direkt Strom verteilt, und **dadurch**, dass der Schritt der Änderung des Wertes der Impedanz beinhaltet:
- einen Teilschritt (24) der Bestimmung des Wertes der variablen Impedanz (18), der die Verteilung eines Nennstroms zur Folge hat; und
- einen Teilschritt (26, 28, 30, 32) der Änderung des Wertes der variablen Impedanz (18) in regelmäßigen Intervallen, um den Wert des verteilten Stroms schrittweise zu erhöhen, bis der Wert des Ausfallstroms erreicht wird.

5. Verfahren nach Anspruch 4, **dadurch gekennzeichnet, dass** die Bestimmung (20) des Prüfstromwertes auch einen Schritt (32) der Auswechselung der geprüften Einrichtung (2) beinhaltet.

6. Verfahren nach Anspruch 3, **dadurch gekennzeichnet, dass** der Ausgang (10) Strom durch ein Schutzelement (12) zum Schutz vor Überstrom hindurch verteilt, das dazu vorgesehen ist, die Verteilung eines Stroms zu ermöglichen, der kleiner als ein maximaler Grenzwert ist, und **dadurch**, dass der Schritt der Änderung des Wertes der variablen Impedanz beinhaltet:
- einen Teilschritt (60) der Bestimmung eines Wertes der variablen Impedanz (18), der die Verteilung eines Stroms zur Folge hat, der größer als der maximale Grenzwert ist; und
- bei jeder Unterbrechung der Verteilung von Strom durch das Schutzelement (12), einen Teilschritt (66) der Änderung des Wertes der variablen Impedanz (18), um den Wert des verteilten Stroms schrittweise zu verringern, und einen Teilschritt (68) der Auswechselung des Schutzelements (12) bis zur Erzielung eines verteilten Stroms, der die Verteilung nicht unterbricht,
und **dadurch**, dass der Schritt der Zuweisung (76) die Zuweisung dieses letzten Stromwertes zu dem Prüfstrom beinhaltet.

7. Verfahren nach Anspruch 6, **dadurch gekennzeichnet, dass**, solange die Dauer des Teilschrittes(68) der Auswechselung des Schutzelements (12) im Vergleich zur Prüfdauer kurz ist, die Dauer des Schrittes (22) der Bestimmung des Ausfallstroms von der Prüfdauer abgeleitet wird.

8. Verfahren nach einem der Ansprüche 1 und 2, **dadurch gekennzeichnet, dass** der Ausgang (14) Strom mittels einer elektronischen Schaltung (16) verteilt, die mit der Einrichtung (2) integriert ist, und **dadurch**, dass die Bestimmung (20) des Prüfstroms beinhaltet:
- einen Schritt (80) der Bestimmung des maximalen Stroms, der durch den Ausgang (14) lieferbar ist, durch Änderung des Wertes der variablen Impedanz (18) in regelmäßigen Intervallen, so dass der gesamte Änderungsbereich dieser Impedanz (18) durchlaufen wird; und
- einen Schritt (94) der Zuweisung des maximalen Wertes, der von dem verteilten Strom erreicht wird, zu dem Prüfstrom.

9. Verfahren nach Anspruch 8, **dadurch gekennzeichnet, dass** es außerdem, vor der Bewertung (50) des Funktionszustands der Einrichtung (2), beinhaltet:
- die beschleunigte Alterung (100) der Einrichtung (2); und
- die Bestimmung eines Ausfallstromwertes, der die Verteilung von Strom durch den Ausgang (14) unterbricht, durch die Anpassung des Wertes der variablen Impedanz (18).

10. Verfahren nach Anspruch 9, **dadurch gekennzeichnet, dass** die Alterung (100) der Einrichtung beinhaltet:
- einen Schritt (102) der Exposition der Einrichtung (2) gegenüber verschlechterten Betriebsbedingungen;
- einen Schritt (104) der Bestimmung des Wertes der variablen Impedanz, der die Verteilung des Prüfstroms zur Folge hat; und
- einen Schritt (106) von schnellen Wechseln von Zyklen der Aktivierung und Deaktivierung der Einrichtung (2) bis zur Unterbrechung der Stromverteilung.

11. Verfahren nach einem der Ansprüche 9 und 10,
**dadurch gekennzeichnet, dass** die Bestimmung (110) des Ausfallstroms beinhaltet:
- einen Schritt (112) der Bestimmung des Wertes der variablen Impedanz, der die Verteilung eines Nennstroms zur Folge hat; und
- einen Schritt (114, 116, 118, 120) der Änderung des Wertes der variablen Impedanz (18) in regelmäßigen Intervallen, um den Wert des verteilten Stroms schrittweise zu erhöhen, bis der Wert des Ausfallstroms erreicht wird.

12. Verfahren nach einem der Ansprüche 1 bis 11, **dadurch gekennzeichnet, dass** die Aufrechterhaltung (40) eines verteilten Stroms, der im Wesentlichen gleich dem Prüfstrom ist, einen Schritt (42) der Bestimmung des Wertes der variablen Impedanz (18), der die Verteilung des Stroms zur Folge hat, der im Wesentlichen gleich dem Prüfstrom ist, und die Konstanthaltung des Wertes der variablen Impedanz (18) während der Prüfdauer beinhaltet.

13. Verfahren nach einem der Ansprüche 1 bis 11, **dadurch gekennzeichnet, dass** die Aufrechterhaltung (40) eines verteilten Stroms, der im Wesentlichen gleich dem Prüfstrom ist, einen Schritt (42) der Bestimmung des Wertes der variablen Impedanz (18), der die Verteilung des Stroms zur Folge hat, der im Wesentlichen gleich dem Prüfstrom ist, und einen Schritt der Änderung des Wertes der variablen Impedanz in regelmäßigen Intervallen, um den Prüfstrom während der Prüfdauer aufrechtzuerhalten, beinhaltet.

14. Verfahren nach einem der Ansprüche 1 bis 13, **dadurch gekennzeichnet, dass** die Bewertung (50) des Funktionszustands beinhaltet:
- einen Schritt (52) der visuellen Kontrolle des Zustands der Einrichtung (2);
- einen Schritt (54) der Prüfung der Funktionsweise der Einrichtung (2) unter Nennbedingungen; und
- einen Schritt (56) der Klassifizierung des Funktionszustands der Einrichtung (2) in Abhängigkeit von dem Prüfschritt.

15. Verfahren nach Anspruch 14, **dadurch gekennzeichnet, dass** die Bewertung (50) des Funktionszustands der Einrichtung außerdem einen Schritt (58) der Validierung der Einrichtung (2) beinhaltet, der insbesondere einen Teilschritt der Bestimmung des Grades der Brandgefahr beinhaltet.

16. Verfahren nach einem der Ansprüche 1 bis 15,
**dadurch gekennzeichnet, dass** es auch eine Prüfung der Überstromfestigkeit beinhaltet, die an einer anderen Einrichtung durchgeführt wird, die der geprüften Einrichtung (2) ähnlich ist, und das Kurzschließen des Ausgangs (8, 10, 14) mit der Masse (6) während der Prüfdauer beinhaltet.

17. Verfahren nach einem der Ansprüche 1 bis 16, **dadurch gekennzeichnet, dass** die Bestimmung des Prüfstroms und die Aufrechterhaltung des verteilten Stroms während einer bestimmten Dauer unter Nennbetriebsbedingungen der Einrichtung durchgeführt werden, wenigstens was die Anschlusstechnik, die Stromversorgung und die Platzverhältnisse anbelangt.

18. Verfahren nach einem der Ansprüche 1 bis 17, **dadurch gekennzeichnet, dass** es parallel an mehreren ähnlichen elektrischen Einrichtungen durchgeführt wird.

19. Verfahren zur Prüfung der Überstromfestigkeit einer einen oder mehrere Stromausgänge aufweisenden elektrischen Einrichtung (2), die sich an Bord eines Kraftfahrzeugs befindet und zwischen einer Stromversorgung (4) und einer Masse (6) geschaltet ist, **dadurch gekennzeichnet, dass** es ein Prüfverfahren nach einem der Ansprüche 1 bis 18 beinhaltet, das nacheinander an jedem der Ausgänge durchgeführt wird.
